# EUROPEAN PATENT APPLICATION

(11) **EP 4 704 535 A1**
(43) Date of publication of application: **04.03.2026**
(21) Application number: 25188967.1
(22) Date of filing: 11.07.2025
(51) Int. Cl.: H10K 59/124, H10K 59/35, H10K 59/80, H10K 102/00

(54) **DISPLAY PANEL, ELECTRONIC DEVICE, AND METHOD OF MANUFACTURING THE DISPLAY PANEL**

(30) Priority: 26.08.2024 KR 20240114611
(71) Applicant: Samsung Display Co., Ltd., Yongin-si, Gyeonggi-do 17113 (KR)
(72) Inventor: Kim, Hyomin, 17113 Giheung-gu, Yongin-si, Gyeonggi-do (KR); Yoo, Gi-Na, 17113 Giheung-Gu, Yongin-si, Gyeonggi-Do (KR); Hong, Sang Min, 17113 Giheung-gu, Yongin-si, Gyeonggi-do (KR); Heo, Nari, 17113 Giheung-Gu, Yongin-si, Gyeonggi-Do (KR)
(74) Representative: Dr. Weitzel & Partner

(57) **Abstract**

A display panel includes a circuit element layer including a circuit element and an insulating layer, a display element layer disposed on the circuit element layer and including a first light emitting element which emits a first color light, a second light emitting element which emits a second color light different from the first color light, and a third light emitting element which emits a third color light different from the first and second color lights, and an encapsulation layer disposed on the display element layer. The first light emitting element includes a first sub-light emitting element and a second sub-light emitting element, and a first length from first sub-light emitting element to the encapsulation layer is different from a second length from the second sub-light emitting element to the encapsulation layer.

## Description

The present invention relates to a display panel, an electronic device, and a method of manufacturing the display panel. More particularly, embodiments of the invention relate to a display panel with improved display quality, an electronic device, and a method of manufacturing the display panel.

Display devices, such as a television set, a monitor, a smart phone, a tablet computer, or the like, which provide a user with images, may include a display panel to display the images. As the display panel, various types of display panel, such as a liquid crystal display panel, an organic light emitting display panel, an electrowetting display panel, an electrophoretic display panel, etc., are being developed.

Embodiments of the invention provide a display panel with improved display quality.

Embodiments of the invention provide an electronic device including the display panel.

Embodiments of the invention provide a method of manufacturing the display panel.

The present invention is defined by the features of the independent claims. The dependent claims and the description provide preferred embodiments.

Embodiments of the invention provide a display panel including a circuit element layer including a lower surface and an upper surface facing the lower surface, or in other words the upper surface facing away from the lower surface, where the circuit element layer includes a circuit element and an insulating layer, a display element layer on the circuit element layer, where the display element layer includes a first light emitting element which emits a first color light, a second light emitting element which emits a second color light different from the first color light, and a third light emitting element which emits a third color light different from the first and second color lights, and an encapsulation layer on the display element layer. In such embodiments, the first light emitting element includes a first sub-light emitting element and a second sub-light emitting element, and a first length from the lower surface of the circuit element layer to the upper surface of the circuit element layer on which an anode of the first sub-light emitting element is disposed is different from a second length from the lower surface of the circuit element layer to the upper surface of the circuit element layer on which an anode of the second sub-light emitting element is disposed. In other words, the thickness of a first portion of the circuit element layer on which the anode of the first sub-light emitting element is disposed is different from the thickness of a second portion of the circuit element layer on which the anode of the second sub-light emitting element is disposed.

In an embodiment, a third length from the lower surface of the circuit element layer to the upper surface of the circuit element layer on which an anode of the second light emitting element is disposed and a fourth length from the lower surface of the circuit element layer to the upper surface of the circuit element layer on which an anode of the third light emitting element is disposed may be substantially the same as the second length.

In an embodiment, the third length from the lower surface of the circuit element layer to the upper surface of the circuit element layer on which an anode of the second light emitting element is disposed and the fourth length from the lower surface of the circuit element layer to the upper surface of the circuit element layer on which an anode of the third light emitting element is disposed may be substantially the same as the first length.

In an embodiment, the third length from the lower surface of the circuit element layer to the upper surface of the circuit element layer on which an anode of the second light emitting element is disposed may be substantially the same as the first length, and the fourth length from the lower surface of the circuit element layer to the upper surface of the circuit element layer on which an anode of the third light emitting element is disposed may be substantially the same as the second length.

In an embodiment, the insulating layer of the circuit element layer may have a step, especially a thickness defining a step, and the insulating layer may include a first portion with a relatively lower height of its upper surface and a second portion with a relatively higher height of its upper surface. That is, the upper surface of insulating layer in the first portion may be on a lower level and therefore may have a larger distance to the encapsulation layer than the upper surface of the insulating layer in the second portion.

In an embodiment, the first portion may overlap the first sub-light emitting element, and the second portion may overlap the second sub-light emitting element.

In an embodiment, the circuit element of the circuit element layer may overlap the second portion.

In an embodiment, the first length may be smaller than the second length.

In an embodiment, the display panel may further include a coupling member which couples the display element layer to the encapsulation layer.

In an embodiment, the encapsulation layer may be a glass substrate.

Embodiments of the invention provide a display panel including a circuit element layer including a lower surface and an upper surface facing the lower surface, where the circuit element layer includes a circuit element and an insulating layer, a display element layer on the circuit element layer, where the display element layer includes a first light emitting element which emits a first color light, a second light emitting element which emits a second color light different from the first color light, and a third light emitting element which emits a third color light different from the first and second color lights, and an encapsulation layer on the display element layer. In such embodiments, The insulating layer includes a first portion with a relatively lower height of its upper surface and a second portion with a relatively higher height of its upper surface, and the first light emitting element includes a first sub-light emitting element and a second sub-light emitting element. That is, the upper surface of insulating layer in the first portion is on a lower level and therefore may have a larger distance to the encapsulation layer than the upper surface of the insulating layer in the second portion. This may be reached, as described above, by providing the insulating layer and especially the whole circuit element layer with a varying thickness, especially a stepped thickness comprising the first portion with a relatively smaller thickness than the second portion. However, this may also reached with a constant thickness of the insulating layer or the circuit element layer, when the lower surface of the insulating layer or the lower surface of the circuit element layer is on different levels with a first portion on a comparatively lower level than a second portion.

In an embodiment, a first length from the lower surface of the circuit element layer to the upper surface of the circuit element layer on which an anode of the first sub-light emitting element is disposed may be smaller than a second length from the lower surface of the circuit element layer to the upper surface of the circuit element layer on which an anode of the second sub-light emitting element is disposed.

In an embodiment, a third length from the lower surface of the circuit element layer to the upper surface of the circuit element layer on which an anode of the second light emitting element is disposed and a fourth length from the lower surface of the circuit element layer to the upper surface of the circuit element layer on which an anode of the third light emitting element is disposed may be substantially the same as one of the first length and the second length.

In an embodiment, the first portion may overlap the first sub-light emitting element, and the second portion may overlap the second sub-light emitting element.

In an embodiment, the circuit element of the circuit element layer may overlap the second portion.

In an embodiment, the encapsulation layer may be a glass substrate, and the display panel may further include a coupling member which couples the display element layer to the encapsulation layer.

Embodiments of the invention provide an electronic device including a display panel according to the present invention which displays an image, a window on the display panel, and a housing disposed under the display panel and coupled to the window.

Embodiments of the invention provide a method of manufacturing a display panel. The method includes forming a circuit element on a base layer, forming an insulating layer to cover the circuit element, forming a first light emitting element which emits a first color light on the insulating layer, forming a second light emitting element which emits a second color light different from the first color light on the insulating layer, forming a third light emitting element which emits a third color light different from the first and second color lights on the insulating layer, and forming an encapsulation layer on the first, second, and third light emitting elements. In such embodiments, the forming the first light emitting element on the insulating layer includes forming a first sub-light emitting element and forming a second sub-light emitting element. In such embodiments, a first length from a lower surface of the circuit element to an upper surface of the circuit element on which an anode of the first sub-light emitting element is disposed is smaller than a second length from the lower surface of the circuit element to the upper surface of the circuit element on which an anode of the second sub-light emitting element is disposed. In other words, the thickness of a first portion of the circuit element layer on which the anode of the first sub-light emitting element is disposed is different from the thickness of a second portion of the circuit element layer on which the anode of the second sub-light emitting element is disposed.

In an embodiment, the forming the insulating layer to cover the circuit element may include forming the insulating layer including a first portion with a relatively lower height of its upper surface and a second portion with a relatively higher height of its upper surface, where the first portion may overlap the first sub-light emitting element, and the second portion may overlap the second sub-light emitting element. That is, the upper surface of insulating layer in the first portion may be on a lower level and therefore may have a larger distance to the encapsulation layer than the upper surface of the insulating layer in the second portion.

In an embodiment, the forming the insulating layer to cover the circuit element may include forming a preliminary insulating layer covering the circuit element, placing a mask including a transmission portion through which a light is transmitted, a non-transmission portion by which the light is blocked, and a semi-transmission portion having a light transmittance lower than the transmission portion on the preliminary insulating layer, and radiating the light onto the preliminary insulating layer through the mask to form the insulating layer including a first portion with a relatively lower height of its upper surface and a second portion with a relatively higher height of its upper surface, where the first portion may be formed by the semi-transmission portion, and the second portion may be formed by the non-transmission portion.

In an embodiment, the forming the insulating layer to cover the circuit element may include forming the insulating layer including a first portion with a relatively lower height of its upper surface and a second portion with a relatively higher height of its upper surface, where the second portion may overlap the circuit element.

According to embodiments, as described above, the first light emitting element of the display panel that emits the first color light includes the first sub-light emitting element and the second sub-light emitting element. In such embodiments, the distance from the first sub-light emitting element to the encapsulation layer is different from the distance from the second sub-light emitting element to the encapsulation layer, the first sub-light emitting element and the second sub-light emitting element have different wavelengths from each other. The wavelength of the first sub-light emitting element and the wavelength of the second sub-light emitting element compensate for each other, and thus, a rainbow phenomenon or a multiple reflection interference (MRI) phenomenon is substantially reduced or effectively prevented.

### BRIEF DESCRIPTION OF THE DRAWINGS

The above and other features of embodiments of the invention will become readily apparent by reference to the following detailed description when considered in conjunction with the accompanying drawings, in which:
FIG. 1A is a perspective view of an electronic device according to an embodiment of the invention;
FIG. 1B is an exploded perspective view of an electronic device according to an embodiment of the invention;
FIG. 2 is a cross-sectional view of a display module according to an embodiment of the invention;
FIG. 3 is an enlarged plan view of a portion of a display area of a display panel according to an embodiment of the invention;
FIG. 4 is a cross-sectional view of a display panel taken along line I-I' of FIG. 3;
FIG. 5 is a cross-sectional view of a display panel taken along line I-I' of FIG. 3;
FIG. 6 is a cross-sectional view of a display panel taken along line I-I' of FIG. 3;
FIGS. 7 and 8 are cross-sectional views illustrating processes of a method of manufacturing a display panel according to an embodiment of the invention;
FIG. 9 is an enlarged plan view of a portion of a display area of a display panel according to an embodiment of the invention; and
FIG. 10 is an enlarged plan view of a portion of a display area of a display panel according to an embodiment of the invention.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

It will be understood that when an element is referred to as being "on" another element, it can be directly on the other element or intervening elements may be present therebetween. In contrast, when an element is referred to as being "directly on" another element, there are no intervening elements present. In the invention, it will be understood that when an element (or area, layer, or portion) is referred to as being "connected to" or "coupled to" another element or layer, it can be directly connected or coupled to the other element or layer or intervening elements or layers may be connected or coupled therebetween.

Like numerals refer to like elements throughout. In the drawings, the thickness, ratio, and dimension of components are exaggerated for effective description of the technical content.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms including technical and scientific terms used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the invention will be described in detail with reference to the accompanying drawings.

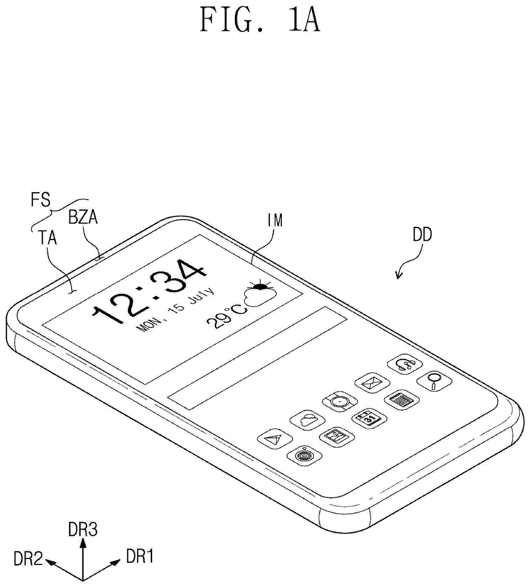

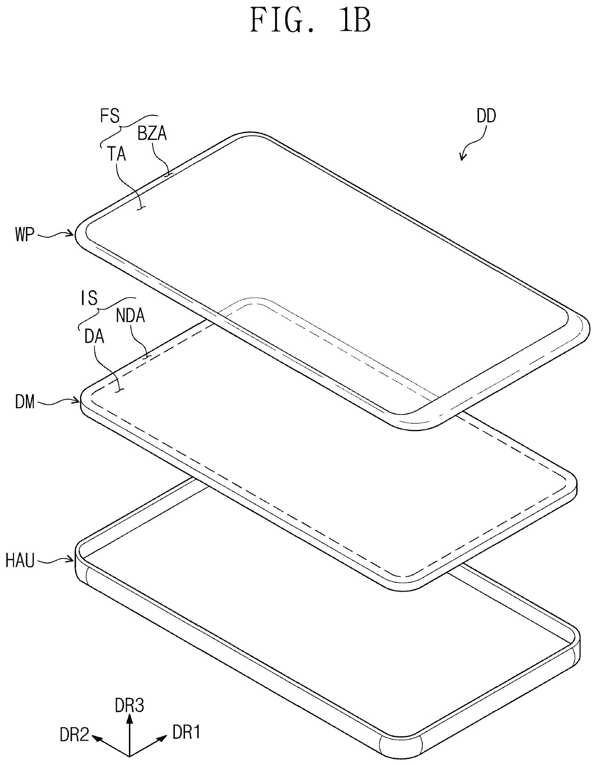

FIG. 1A is a perspective view of an electronic device DD according to an embodiment of the invention. FIG. 1B is an exploded perspective view of the electronic device DD according to an embodiment of the invention.

An embodiment of the electronic device DD may be applied to a large-sized electronic item, such as a television set, a monitor, or an outdoor billboard. In addition, an embodiment of the electronic device DD may be applied to a small and medium-sized electronic item, such as a personal computer, a notebook computer, a personal digital assistant, a car navigation unit, a game unit, a smartphone, a tablet computer, or a camera. However, these are merely examples, and the electronic device DD may be employed in other electronic devices as long as they do not deviate from the concept of the invention. In FIGS. 1A and 1B, an embodiment where the electronic device DD is a smartphone is illustrated as an example.

Referring to FIGS. 1A and 1B, an embodiment of the electronic device DD may display an image IM through a display surface FS, which is substantially parallel to each of a first direction DR1 and a second direction DR2, toward a third direction DR3. The image IM may include a video and a still image. FIG. 1A shows a clock widget and application icons as an example of the image IM. The display surface FS through which the image IM is displayed may correspond to a front surface of the electronic device DD.

In the invention, front (or upper) and rear (or lower) surfaces of each member of the electronic device DD may be defined with respect to a direction in which the image IM is displayed. The front and rear surfaces may be opposite to each other in the third direction DR3, and a normal line direction of each of the front and rear surfaces may be substantially parallel to the third direction DR3. In the invention, directions indicated by the first, second, and third directions DR1, DR2, and DR3 may be relative to each other, and thus, the directions indicated by the first, second, and third directions DR1, DR2, and DR3 may be changed to other directions. In the following descriptions, the expression "when viewed in a plane" or "in a plan view" means a state of being viewed in the third direction DR3.

In an embodiment, the electronic device DD may include a window WP, a display module DM, and a housing HAU. The window WP and the housing HAU may be coupled to each other to provide an exterior of the electronic device DD.

The window WP may include an optically transparent insulating material. In an embodiment, for example, the window WP may include a glass or plastic material. A front surface of the window WP may define the display surface FS of the electronic device DD. The display surface FS may include a transmissive area TA and a bezel area BZA. The transmissive area TA may be an optically transparent area. In an embodiment, for example, the transmissive area TAmay be an area having a visible light transmittance of about 90% or greater.

The bezel area BZA may be an area having a relatively lower transmittance than that of the transmissive area TA. The bezel area BZA may define a shape of the transmissive area TA. The bezel area BZA may be disposed adjacent to the transmissive area TA and may surround the transmissive area TA. However, this is merely an example, and the bezel area BZA may be omitted from the window WP according to another embodiment of the invention. The window WP may include at least one functional layer selected from an anti-fingerprint layer, a hard coating layer, and an anti-reflective layer and should not be particularly limited.

The display module DM may be disposed under the window WP. The display module DM may have a configuration that substantially generates the image IM. The image IM generated by the display module DM may be displayed through a display surface IS of the display module DM and may be viewed by a user through the transmissive area TA.

The display module DM may include a display area DA and a non-display area NDA. The display area DA may be activated in response to electrical signals. The non-display area NDA may be adjacent to the display area DA. The non-display area NDA may surround the display area DA. The non-display area NDA may be covered by the bezel area BZA and may not be viewed from the outside.

The housing HAU may be coupled with the window WP. The housing HAU and the window WP coupled to the housing HAU may provide a predetermined inner space. The display module DM may be accommodated in the inner space.

The housing HAU may include a material with a relatively high rigidity. In an embodiment, for example, the housing HAU may include a glass, plastic, or metal material or a plurality of frames and/or plates of combinations thereof. The housing HAU may stably protect the components of the electronic device DD accommodated in the inner space from external impacts.

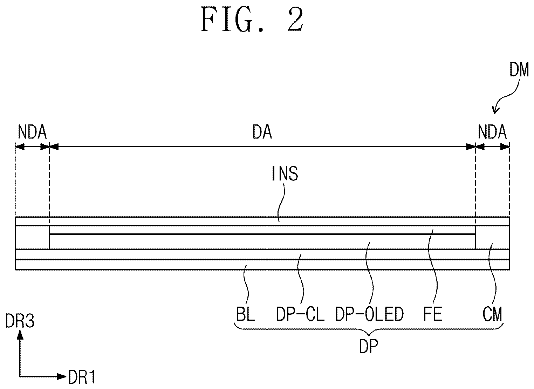

FIG. 2 is a cross-sectional view of the display module DM according to an embodiment of the invention.

Referring to FIG. 2, an embodiment of the display module DM may include a display panel DP and an input sensor INS. Although not shown in figures, the electronic device DD (refer to FIG. 1A) may further include a protective member disposed on a lower surface of the display panel DP or an anti-reflective member and/or a window member disposed on an upper surface of the input sensor INS.

The display panel DP may be a light emitting type display panel, however, it should not be particularly limited. In an embodiment, for example, the display panel DP may be an organic light emitting display panel or an inorganic light emitting display panel. A light emitting layer of the organic light emitting display panel may include an organic light emitting material. A light emitting layer of the inorganic light emitting display panel may include a quantum dot, a quantum rod, or a micro-light emitting diode (LED). Hereinafter, the organic light emitting display panel will be described as the display panel DP.

The display panel DP may include a base layer BL, a circuit element layer DP-CL, a display element layer DP-OLED, an encapsulation layer FE, and a coupling member CM. The circuit element layer DP-CL, the display element layer DP-OLED, the encapsulation layer FE, and the coupling member CM may be disposed on the base layer BL. The input sensor INS may be disposed directly on the encapsulation layer FE. In the invention, the expression "a component A is disposed directly on a component B" means that no adhesive layers are present between the component A and the component B.

The base layer BL may include at least one plastic film. The base layer BL may be a flexible substrate and may include a plastic substrate, a glass substrate, a metal substrate, or an organic/inorganic composite material substrate. In the invention, the display area DA and the non-display area NDA described with reference to FIG. 1B may be defined in the base layer BL of FIG. 2.

The circuit element layer DP-CL may include at least one insulating layer and a circuit element. The insulating layer may include at least one inorganic layer and at least one organic layer. The circuit element may include signal lines and a pixel driving circuit.

The display element layer DP-OLED may include a pixel definition layer and a light emitting element. The light emitting element may include an anode, a light emitting pattern, and a cathode.

The encapsulation layer FE may be disposed on the display element layer DP-OLED. The encapsulation layer FE may be a glass substrate. The encapsulation layer FE and the display element layer DP-OLED may be coupled to each other by the coupling member CM. The coupling member CM may be disposed in the non-display area NDA. A space between the encapsulation layer FE and the display element layer DP-OLED may be an empty space, however, this is merely an example. According to an embodiment, the space between the encapsulation layer FE and the display element layer DP-OLED may be filled with a transparent material.

The input sensor INS may obtain coordinate information of an external input. The input sensor INS may have a multi-layer structure. The input sensor INS may include a conductive layer having a single-layer or multi-layer structure. The input sensor INS may include an insulating layer having a single-layer or multi-layer structure. The input sensor INS may sense the external input by a capacitive method. However, the operation method of the input sensor INS should not be particularly limited. In an embodiment, for example, the input sensor INS may sense the external input by an electromagnetic induction method or a pressure sensing method. According to another embodiment, the input sensor INS may be omitted.

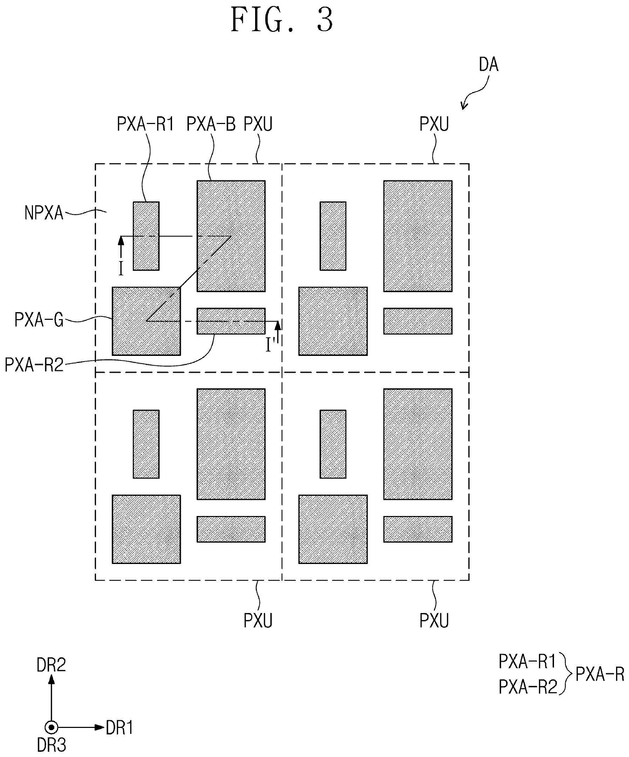

FIG. 3 is an enlarged plan view of a portion of the display area DA of the display panel DP (refer to FIG. 2) according to an embodiment of the invention. FIG. 3 is a plan view showing the display module DM (refer to FIG. 1B) when viewed from the above of the display surface IS (refer to FIG. 1B) of the display module DM and shows an arrangement of light emitting areas PXA-R, PXA-G, and PXA-B.

Referring to FIG. 3, in an embodiment, the display area DA may include first, second, and third light emitting areas PXA-R, PXA-G, and PXA-B and a peripheral area NPXA surrounding the first, second, and third light emitting areas PXA-R, PXA-G, and PXA-B. The first, second, and third light emitting areas PXA-R, PXA-G, and PXA-B may respectively correspond to areas from which lights provided from light emitting elements are emitted. The first, second, and third light emitting areas PXA-R, PXA-G, and PXA-B may be distinguished by colors of the lights emitted outward from the display module DM (refer to FIG. 2).

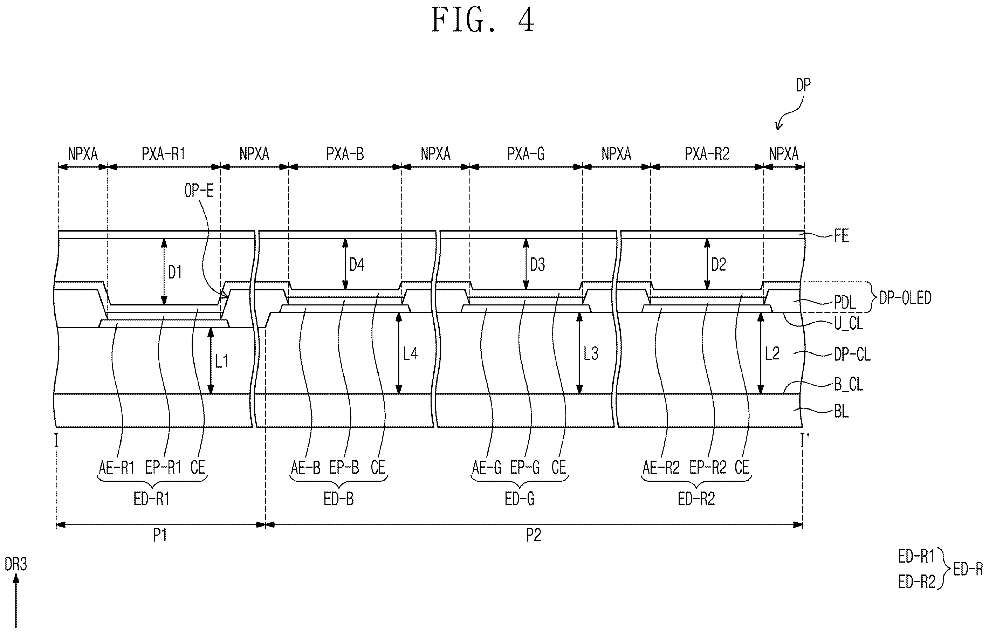

A first light emitting element ED-R (refer to FIG. 4) may provide (generate or emit) a first color light, a second light emitting element ED-G (refer to FIG. 4) may provide a second color light, and a third light emitting element ED-B (refer to FIG. 4) may provide a third color light. The second color light may be different from the first color light, and the third color light may be different from the first and second color lights. In an embodiment, for example, the first color light may be a red light, the second color light may be a green light, and the third color light may be a blue light. However, the first, second, and third color lights should not be limited thereto or thereby.

Each of the first, second, and third light emitting areas PXA-R, PXA-G, and PXA-B may be defined as an area through which a portion of an upper surface of the anode is exposed by a light emitting opening described later. In an embodiment, for example, the first light emitting area PXA-R may be defined as an area through which an upper surface of a first anode AE-R1 and AE-R2 (refer to FIG. 4) is exposed by the light emitting opening OP-E, the second light emitting area PXA-G may be defined as an area through which an upper surface of a second anode AE-G (refer to FIG. 4) is exposed by the light emitting opening, and the third light emitting area PXA-B may be defined as an area through which an upper surface of a third anode AE-B (refer to FIG. 4) is exposed by the light emitting opening. The peripheral area NPXA may define a boundary between the first, second, and third light emitting areas PXA-R, PXA-G, and PXA-B and may effectively prevent a mixture of the colors of the lights between the first, second, and third light emitting areas PXA-R, PXA-G, and PXA-B.

Each of the first, second, and third light emitting areas PXA-R, PXA-G, and PXA-B may be provided in plural and may be repeatedly arranged in a predetermined arrangement within the display area DA. In an embodiment, for example, the first light emitting area PXA-R may include a first sub-light emitting area PXA-R1 and a second sub-light emitting area PXA-R2, and one first sub-light emitting area PXA-R1, one second sub-light emitting area PXA-R2, one second light emitting area PXA-G, and one third light emitting area PXA-B may form (or collectively define) one pixel unit PXU and the pixel unit PXU may be repeatedly arranged. In an embodiment, for example, the pixel unit PXU may be provided in plural, and the pixel units PXU may be arranged in the first direction DR1 or the second direction DR2. FIG. 3 shows four pixel units PXU adjacent to each other as an example.

The first sub-light emitting area PXA-R1 and the third light emitting area PXA-B may be alternately arranged with each other in the first direction DR1 to form a first group. The second sub-light emitting area PXA-R2 and the second light emitting area PXA-G may be alternately arranged in the first direction DR1 to form a second group. Each of the first group and the second group may be provided in plural, and the first groups may be alternately arranged with the second groups in the second direction DR2.

FIG. 3 shows the arrangement of the first, second, and third light emitting areas PXA-R, PXA-G, and PXA-B in an embodiment, however, the arrangement of the first, second, and third light emitting areas PXA-R, PXA-G, and PXA-B should not be particularly limited and may be changed in various ways. The first, second, and third light emitting areas PXA-R, PXA-G, and PXA-B may be arranged in a pentile pattern (PENTILE^{™}), a stripe pattern, or a diamond pattern (Diamond Pixel^{™}).

Each of the first, second, and third light emitting areas PXA-R, PXA-G, and PXA-B may have one of a variety of shapes when viewed in a plane, that is, one of various planar shapes in a plan view. In an embodiment, for example, each of the first, second, and third light emitting areas PXA-R, PXA-G, and PXA-B may have a polygonal shape, a circular shape, or an oval shape. In FIG. 3, an embodiment where the first to third light emitting areas PXA-R to PXA-B each have a quadrangular shape when viewed in the plane is shown as an example.

The first, second, and third light emitting areas PXA-R, PXA-G, and PXA-B may have substantially the same shape as each other when viewed in the plane, or at least one selected from the first, second, and third light emitting areas PXA-R, PXA-G, and PXA-B may have a shape different from the others. FIG. 3 shows an embodiment where the first and second sub-light emitting areas PXA-R1 and PXA-R2 have a same shape as each other and the second and third light emitting areas PXA-G and PXA-B have different shapes from each other when viewed in the plane as an example.

At least one selected from the first, second, and third light emitting areas PXA-R, PXA-G, and PXA-B may have a size (e.g., a planar area) different from those of the others when viewed in the plane. The size of the first and second sub-light emitting areas PXA-R1 and PXA-R2 that emits the red light may be smaller than the size of the second light emitting area PXA-G that emits the green light and may be smaller than the size of the third light emitting area PXA-B that emits the blue light. However, a size relationship between the first, second, and third light emitting areas PXA-R, PXA-G, and PXA-B according to the colors of the emitted lights should not be limited thereto or thereby and may be changed in various ways depending on a design of the display module DM (refer to FIG. 2). In addition, according to an embodiment, the first, second, and third light emitting areas PXA-R, PXA-G, and PXA-B may have substantially the same size as each other when viewed in the plane.

In an embodiment, the shape, size, and arrangement of the first, second, and third light emitting areas PXA-R, PXA-G, and PXA-B of the display module DM (refer to FIG. 2) may be variously designed or modified depending on the colors of the emitted lights, the size of the display module DM (refer to FIG. 2), and the configuration of the display module DM (refer to FIG. 2), and they should not be limited to the embodiment shown in FIG. 3.

FIG. 4 is a cross-sectional view of the display panel DP taken along line I-I' of FIG. 3. In FIG. 4, the same reference numerals denote the same elements as those in FIG. 3, and thus, any repetitive detailed descriptions of the same elements will be omitted.

Referring to FIGS. 3 and 4, an embodiment of the display panel DP may include the base layer BL, the circuit element layer DP-CL, the display element layer DP-OLED, and the encapsulation layer FE. The circuit element layer DP-CL may include a lower surface B_CL and an upper surface U_CL facing the lower surface B_CL. The lower surface B_CL of the circuit element layer DP-CL may be disposed adjacent (or close) to the base layer BL, and the upper surface U_CL of the circuit element layer DP-CL may be disposed adjacent to the display element layer DP-OLED.

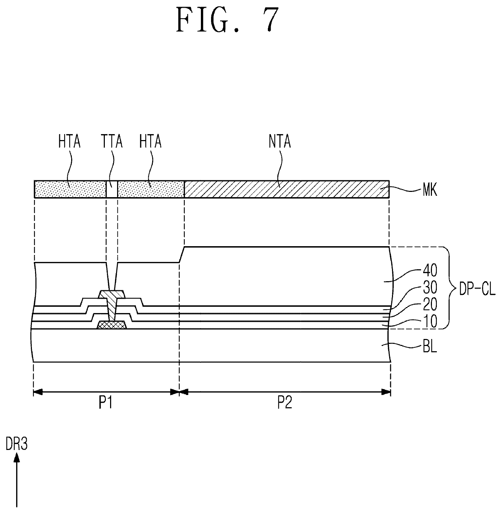

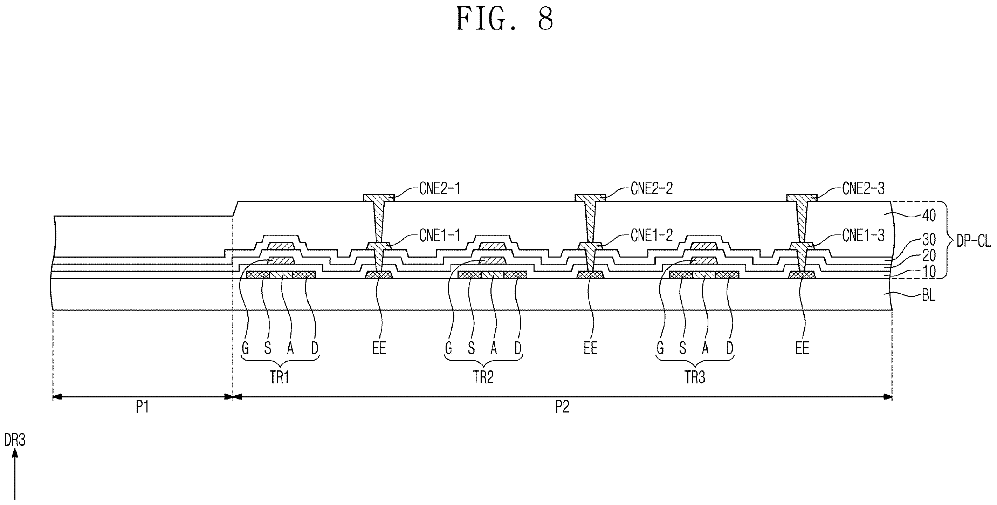

The circuit element layer DP-CL or an insulating layer 40 therein (refer to FIG. 8) may have a step (or a stepped structure). The insulating layer 40 (or the circuit element layer DP-CL) may include a first portion P1 having a relatively higher height (e.g., including an upper surface on a relatively high level or having a relatively thick thickness) and a second portion P2 having a relatively lower height (including an upper surface on a relatively low level or having a relatively thin thickness). According to an embodiment, the insulating layer 40 may be formed using a halftone mask and may have the step, and according to an embodiment, the insulating layer 40 may have the step caused by circuit lines or circuit elements disposed thereunder. These will be described in detail with reference to FIGS. 7 and 8.

The display element layer DP-OLED may include the pixel definition layer PDL, the first light emitting element ED-R, the second light emitting element ED-G, and the third light emitting element ED-B. The first light emitting element ED-R may include the first sub-light emitting element ED-R1 and the second sub-light emitting element ED-R2.

The display element layer DP-OLED may be disposed on the circuit element layer DP-CL. Some of components of the display element layer DP-OLED disposed on the insulating layer 40, which has the step, may be spaced apart from the encapsulation layer FE disposed on the display element layer DP-OLED by different distances. A first distance D1 from the first sub-light emitting element ED-R1 to the encapsulation layer FE in the third direction DR3 may be different from a second distance D2 from the second sub-light emitting element ED-R2 to the encapsulation layer FE in the third direction DR3. In an embodiment, for example, the first distance D1 from the first sub-light emitting element ED-R1 to the encapsulation layer FE in the third direction DR3 may be greater than the second distance D2 from the second sub-light emitting element ED-R2 to the encapsulation layer FE in the third direction DR3. A difference between the first distance D1 and the second distance D2 may be in a range from about 100 nanometers (nm) to about 500 nm.

A length from the lower surface B_CL of the circuit element layer DP-CL to the upper surface U_CL of the circuit element layer DP-CL on which the first anode AE-R1 of the first sub-light emitting element ED-R1 is disposed (i.e., a thickness of a portion of the circuit element layer DP-CL overlapping the first anode AE-R1 of the first sub-light emitting element ED-R1 in the third direction DR3) may be referred to as a first length L1, and a length from the lower surface B_CL of the circuit element layer DP-CL to the upper surface U_CL of the circuit element layer DP-CL on which the first anode AE-R2 of the second sub-light emitting element ED-R2 is disposed (i.e., a thickness of a portion of the circuit element layer DP-CL overlapping the first anode AE-R2 of the second sub-light emitting element ED-R2 in the third direction DR3) may be referred to as a second length L2. The first length L1 may be different from the second length L2. The first length L1 may be smaller than the second length L2.

The first portion P1 of the insulating layer 40 may overlap the first sub-light emitting element ED-R1 in the third direction DR3, and the second portion P2 of the insulating layer 40 may overlap the second sub-light emitting element ED-R2, the second light emitting element ED-G, and the third light emitting element ED-B in the third direction DR3. That is, a distance from the first sub-light emitting element ED-R1, which is disposed on the first portion P1 having the relatively lower height, to the encapsulation layer FE may be greater than a distance from the second sub-light emitting element ED-R2, which is disposed on the second portion P2 having the relatively higher height, to the encapsulation layer FE.

A third distance D3 from the second light emitting element ED-G to the encapsulation layer FE and a fourth distance D4 from the third light emitting element ED-B to the encapsulation layer FE may be substantially the same as the second distance D2. That is, the second light emitting element ED-G, the third light emitting element ED-B, and the second sub-light emitting element ED-R2 may overlap the second portion P2 of the insulating layer 40 in the third direction DR3 and may be disposed at positions different from the first sub-light emitting element ED-R1.

A length from the lower surface B_CL of the circuit element layer DP-CL to the upper surface U_CL of the circuit element layer DP-CL on which the anode AE-G of the second light emitting element ED-G is disposed (i.e., a thickness of a portion of the circuit element layer DP-CL overlapping the anode AE-G of the second light emitting element ED-G in the third direction DR3) may be defined as a third length L3, and a length from the lower surface B_CL of the circuit element layer DP-CL to the upper surface U_CL of the circuit element layer DP-CL on which the anode AE-B of the third light emitting element ED-B is disposed (i.e., a thickness of a portion of the circuit element layer DP-CL overlapping the anode AE-B of the third light emitting element ED-B in the third direction DR3) may be defined as a fourth length L4. The third length L3 and the fourth length L4 may be substantially the same as the second length L2.

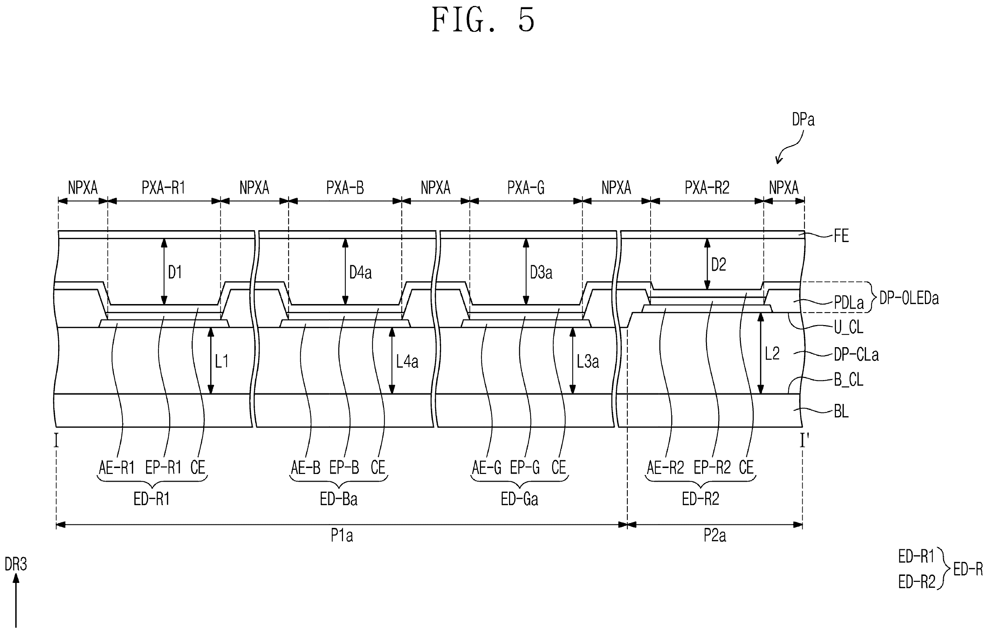

FIG. 5 is a cross-sectional view of a display panel DPa taken along line I-I' of FIG. 3. In FIG. 5, the same reference numerals denote the same elements as those in FIGS. 3 and 4, and thus, any repetitive detailed descriptions of the same elements will be omitted.

Referring to FIGS. 3 and 5, an embodiment of the display panel DPa may include a base layer BL, a circuit element layer DP-CLa, a display element layer DP-OLEDa, and an encapsulation layer FE. The circuit element layer DP-CLa (or an insulating layer (refer to 40 of FIG. 8)) may have a step (or a stepped structure). The insulating layer 40 (or the circuit element layer DP-CLa) may include a first portion P1a having a relatively lower height and a second portion P2a having a relatively higher height.

The display element layer DP-OLEDa may include a pixel definition layer PDLa, a first light emitting element ED-R, a second light emitting element ED-Ga, and a third light emitting element ED-Ba. The display element layer DP-OLEDa may be disposed on the circuit element layer DP-CLa. Some of components of the display element layer DP-OLEDa disposed on the insulating layer 40, which has the step, may be spaced apart from the encapsulation layer FE disposed on the display element layer DP-OLEDa by different distances.

The first portion P1a of the insulating layer 40 may overlap a first sub-light emitting element ED-R1, the second light emitting element ED-Ga, and the third light emitting element ED-Ba in the third direction DR3, and the second portion P2a of the insulating layer 40 may overlap a second sub-light emitting element ED-R2 in the third direction DR3. That is, a distance from the first sub-light emitting element ED-R1, which is disposed on the first portion P1a having the relatively lower height, to the encapsulation layer FE may be greater than a distance from the second sub-light emitting element ED-R2, which is disposed on the second portion P2a having the relatively higher height, to the encapsulation layer FE.

A third distance D3a from the second light emitting element ED-Ga to the encapsulation layer FE and a fourth distance D4a from the third light emitting element ED-Ba to the encapsulation layer FE may be substantially the same as a first distance D1. That is, the second light emitting element ED-Ga, the third light emitting element ED-Ba, and the first sub-light emitting element ED-R1 may overlap the first portion P1a of the insulating layer 40 in the third direction DR3 and may be disposed at different positions from the second sub-light emitting element ED-R2.

A third length L3a from a lower surface B_CL of the circuit element layer DP-CLa to an upper surface U_CL of the circuit element layer DP-CLa on which an anode AE-G of the second light emitting element ED-Ga is disposed and a fourth length L4a from the lower surface B_CL of the circuit element layer DP-CLa to the upper surface U_CL of the circuit element layer DP-CLa on which an anode AE-B of the third light emitting element ED-Ba is disposed may be substantially the same as a first length L1.

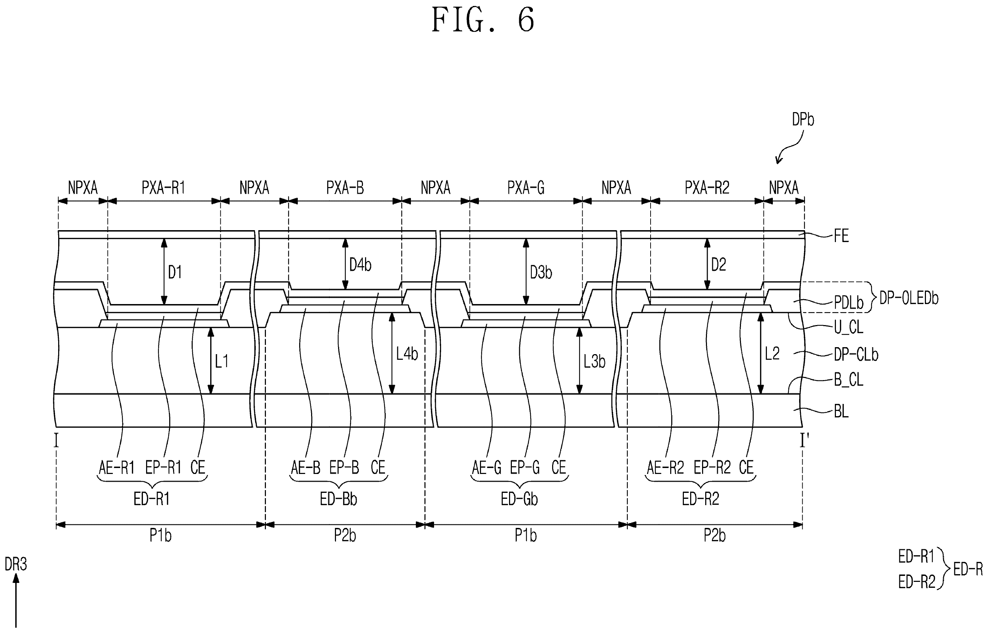

FIG. 6 is a cross-sectional view of a display panel DPb taken along line I-I' of FIG. 3. In FIG. 6, the same reference numerals denote the same elements as those in FIGS. 3 and 4, and thus, any repetitive detailed descriptions of the same elements will be omitted.

Referring to FIGS. 3 and 6, an embodiment of the display panel DPb may include a base layer BL, a circuit element layer DP-CLb, a display element layer DP-OLEDb, and an encapsulation layer FE. The circuit element layer DP-CLb (or an insulating layer (refer to 40 of FIG. 8)) may have a step (or a stepped structure). The insulating layer 40 (or the circuit element layer DP-CLb) may include a first portion P1b having a relatively lower height and a second portion P2b having a relatively higher height.

The display element layer DP-OLEDb may include a pixel definition layer PDLb, a first light emitting element ED-R, a second light emitting element ED-Gb, and a third light emitting element ED-Bb. The display element layer DP-OLEDb may be disposed on the circuit element layer DP-CLb. Some of components of the display element layer DP-OLEDb disposed on the insulating layer 40, which has the step, may be spaced apart from the encapsulation layer FE disposed on the display element layer DP-OLEDb by different distances.

The first portion P1b of the insulating layer 40 may overlap a first sub-light emitting element ED-R1 and the second light emitting element ED-Gb in the third direction DR3, and the second portion P2b of the insulating layer 40 may overlap a second sub-light emitting element ED-R2 and the third light emitting element ED-Bb in the third direction DR3. That is, a distance from the first sub-light emitting element ED-R1, which is disposed on the first portion P1b having the relatively lower height, to the encapsulation layer FE may be greater than a distance from the second sub-light emitting element ED-R2, which is disposed on the second portion P2b having the relatively higher height, to the encapsulation layer FE.

A third distance D3b from the second light emitting element ED-Gb to the encapsulation layer FE may be substantially the same as a first distance D1, and a fourth distance D4b from the third light emitting element ED-Bb to the encapsulation layer FE may be substantially the same as a second distance D2. That is, the second light emitting element ED-Gb and the first sub-light emitting element ED-R1 may overlap the first portion P1b of the insulating layer 40 in the third direction DR3, and the third light emitting element ED-Bb and the second sub-light emitting element ED-R2 may overlap the second portion P2b of the insulating layer 40 in the third direction DR3. The second light emitting element ED-Gb may be disposed at a position different from the third light emitting element ED-Bb.

A third length L3b from a lower surface B_CL of the circuit element layer DP-CLb to an upper surface U_CL of the circuit element layer DP-CLb on which an anode AE-G of the second light emitting element ED-Gb is disposed may be substantially the same as a first length L1, and a fourth length L4b from the lower surface B_CL of the circuit element layer DP-CLb to the upper surface U_CL of the circuit element layer DP-CLb on which an anode AE-B of the third light emitting element ED-Bb is disposed may be substantially the same as a second length L2.

FIGS. 4 to 6 show embodiments having the structure in which the first light emitting element ED-R includes two sub-light emitting elements disposed at different positions as examples, however, the invention should not be limited thereto or thereby. In an embodiment, for example, the second light emitting element ED-G may include two sub-light emitting elements disposed at different positions or the third light emitting element ED-B may include two sub-light emitting elements disposed at different positions.

The first light emitting element ED-R of the display panel DP may include the first sub-light emitting element ED-R1 and the second sub-light emitting element ED-R2, which emit the first color light. Since the first sub-light emitting element ED-R1 and the second sub-light emitting element ED-R2 are spaced apart from the encapsulation layer FE by different distances, the first sub-light emitting element ED-R1 and the second sub-light emitting element ED-R2 may have different wavelengths. The wavelength of the first sub-light emitting element ED-R1 and the wavelength of the second sub-light emitting element ED-R2 may compensate for each other, and thus, a rainbow phenomenon or a multiple reflection interference (MRI) phenomenon may be effectively prevented or substantially reduced.

FIGS. 7 and 8 are cross-sectional views illustrating processes of a method of manufacturing the display panel according to an embodiment of the invention.

Referring to FIGS. 4, 7, and 8, an embodiment of the manufacturing method of the display panel may include forming a circuit element on the base layer BL, forming the insulating layer 40 covering the circuit element, forming the first light emitting element ED-R that emits the first color light on the insulating layer 40, forming the second light emitting element ED-G that emits the second color light different from the first color light on the insulating layer 40, forming the third light emitting element ED-B that emits the third color light different from the first and second color lights on the insulating layer 40, and forming the encapsulation layer FE on the first, second, and third light emitting elements ED-R, ED-G, and ED-B. The forming of the first light emitting element ED-R on the insulating layer 40 may include forming the first sub-light emitting element ED-R1 and forming the second sub-light emitting element ED-R2, and the first distance D1 from the first sub-light emitting element ED-R1 to the encapsulation layer FE may be greater than the second distance D2 from the second sub-light emitting element ED-R2 to the encapsulation layer FE. FIGS. 7 and 8 show a process of the forming of the insulating layer 40 among the processes of an embodiment of the manufacturing method of the display panel.

The forming of the insulating layer 40 covering the circuit element may include forming the insulating layer 40 including the first portion P1 having the relatively lower height and the second portion P2 having the relatively higher height. The first portion P1 may overlap the first sub-light emitting element ED-R1 of FIG. 4 in the third direction DR3, and the second portion P2 may overlap the second sub-light emitting element ED-R2 of FIG. 4 in the third direction DR3.

Referring to FIGS. 7 and 8, a semiconductor pattern may be disposed on the base layer BL. The semiconductor pattern may include polysilicon, however, it should not be limited thereto or thereby. The semiconductor pattern may include an amorphous silicon or metal oxide. FIG. 7 shows a portion of the semiconductor pattern, and the semiconductor pattern may be further disposed in the light emitting areas PXA-R, PXA-G, and PXA-B (refer to FIG. 4). The semiconductor pattern may be arranged with a specific rule over the light emitting areas PXA-R, PXA-G, and PXA-B. The semiconductor pattern may have different electrical properties depending on whether it is doped or not. The semiconductor pattern may include a first region having a relatively high doping concentration and a second region having a relatively low doping concentration. The first region may be doped with an N-type dopant or a P-type dopant. A P-type transistor may include the first region doped with the P-type dopant.

The first region may have a conductivity greater than that of the second region and may substantially serve as an electrode or a signal line. The second region may substantially correspond to an active (or a channel) of a transistor. In other words, a portion of the semiconductor pattern may be the active of the transistor, another portion of the semiconductor pattern may be a source or a drain of the transistor, and the other portion of the semiconductor pattern may be a conductive area. A source S, an active A, and a drain D of each of transistors TR1, TR2, and TR3 may be formed from (or defined by portions of) the semiconductor pattern.

First, second, third, and fourth insulating layers 10, 20, 30, and 40 may be disposed on the base layer BL. Each of the first to fourth insulating layers 10 to 40 may be an inorganic layer or an organic layer.

The first insulating layer 10 may be disposed on the base layer BL. The first insulating layer 10 may cover the source S, the active A, and the drain D of each of the transistors TR1, TR2, and TR3 and electrodes EE, which are disposed on the base layer BL. A gate G of each of the transistors TR1, TR2, and TR3 may be disposed on the first insulating layer 10. The second insulating layer 20 may be disposed on the first insulating layer 10 and may cover the gate G.

First connection electrodes CNE1-1, CNE1-2, and CNE1-3 may be disposed on the third insulating layer 30. The first connection electrodes CNE1-1, CNE1-2, and CNE1-3 may be connected to the electrodes EE via contact holes defined through the first, second, and third insulating layers 10, 20, and 30, respectively. The fourth insulating layer 40 may be disposed on the third insulating layer 30 and may cover the first connection electrodes CNE1-1, CNE1-2, and CNE1-3. The fourth insulating layer 40 may be an organic layer.

Second connection electrodes CNE2-1, CNE2-2, and CNE2-3 may be disposed on the fourth insulating layer 40. The second connection electrodes CNE2-1, CNE2-2, and CNE2-3 may be respectively connected to the first connection electrodes CNE1-1, CNE1-2, and CNE1-3 via contact holes defined or formed through the fourth insulating layer 40.

Referring to FIG. 7, the forming of the insulating layer 40 covering the circuit element may include forming a preliminary insulating layer to cover the circuit element, placing a mask MK on the preliminary insulating layer, and forming the insulating layer 40 including the first portion P1 having the relatively lower height and the second portion P2 having the relatively higher height.

The mask MK may include a transmission portion TTA for transmitting a light, a non-transmission portion NTA for blocking the light, and a semi-transmission portion HTA having a light transmittance lower than that of the transmission portion TTA. The insulating layer 40 formed using the mask MK may have the step. In an embodiment, for example, the insulating layer 40 may include the first portion P1 having the relatively lower height and the second portion P2 having the relatively higher height, and a hole may be formed through the insulating layer 40.

The first portion P1 of the insulating layer 40 may be formed by using the semi-transmission portion HTA of the mask MK, and the second portion P2 of the insulating layer 40 may be formed by using the non-transmission portion NTA. In addition, the hole of the insulating layer 40 may be formed by using the transmission portion TTA of the mask MK. That is, the hole may be formed in a portion of the insulating layer 40 that receives the most light, a portion of the insulating layer 40 that receives an appropriate amount of light may be partially etched to form the first portion P1 with the relatively lower height, and a portion of the insulating layer 40 that is not exposed to light may not be etched and may be formed as the second portion P2 with the relatively higher height.

Referring to FIG. 8, the forming of the insulating layer 40 covering the circuit element may include the forming of the insulating layer 40 including the first portion P1 with the relatively lower height and the second portion P2 with the relatively higher height. The second portion P2 of the insulating layer 40 may overlap the circuit element. That is, the portion of the insulating layer 40, which is disposed on the circuit element (e.g., the transistors TR1, TR2, and TR3), may be defined as the second portion P2, and the portion of the insulating layer 40, which is disposed on an area where the circuit element (e.g., the transistors TR1, TR2, and TR3) is not disposed may be defined as the first portion P1. That is, the circuit element (e.g., the transistors TR1, TR2, and TR3) may overlap the second portion P2. The second portion P2 may have the height greater than that of the first portion P1 due to a thickness of the circuit element (e.g., the transistors TR1, TR2, and TR3). In an embodiment, for example, the second portion P2 may have the height that is greater than that of the first portion P1 by about 100 nm to about 500 nm.

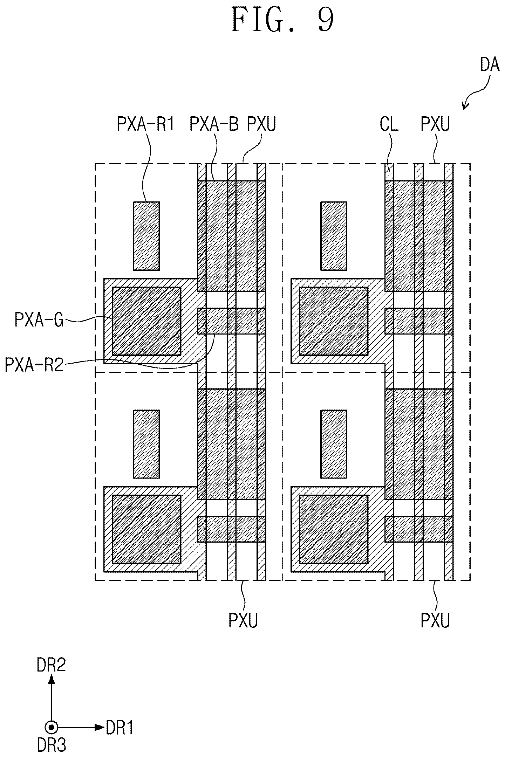

FIG. 9 is an enlarged plan view of a portion of the display area DA of the display panel DP (refer to FIG. 2) according to an embodiment of the invention. In FIG. 9, the same reference numerals denote the same elements as those in FIG. 3, and thus, any repetitive detailed descriptions of the same elements will be omitted. FIG. 9 shows a structure in which a circuit element CL is further illustrated in the display area DA of FIG. 3. The plan view of FIG. 9 may correspond to the cross-sectional view of FIG. 4.

Referring to FIGS. 4 and 9, in an embodiment, the circuit element CL may be disposed to overlap the second light emitting area PXA-G, the third light emitting area PXA-B, and the second sub-light emitting area PXA-R2 in a plan view. The circuit element layer DP-CL may include the insulating layer 40 (refer to FIG. 8) including the first portion P1 with the relatively lower height and the second portion P2 with the relatively higher height. The portion of the insulating layer 40, which is disposed above the circuit element CL, may be defined as the second portion P2, and the portion of insulating layer 40, which is disposed above the area where the circuit element CL is not disposed, may be defined as the first portion P1. The second portion P2 may have the height higher than that of the first portion P1 due to the thickness of the circuit element CL.

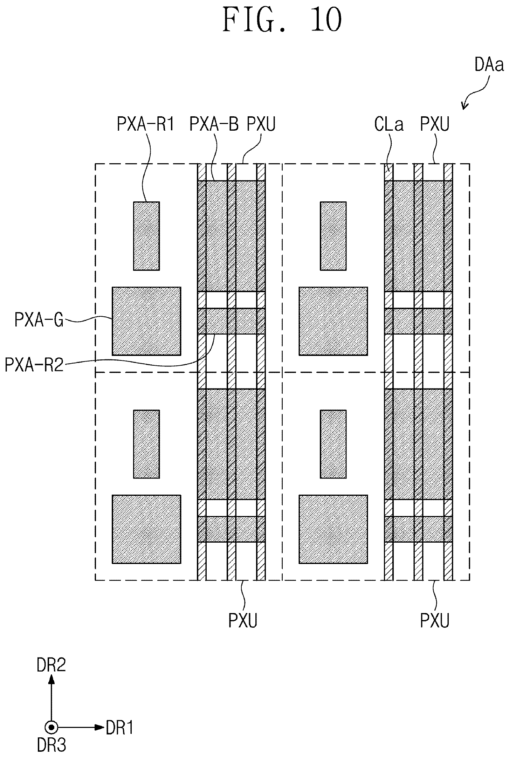

FIG. 10 is an enlarged plan view of a portion of a display area DAa of the display panel DP (refer to FIG. 2) according to an embodiment of the invention. In FIG. 10, the same reference numerals denote the same elements as those in FIG. 3, and thus, any repetitive detailed descriptions of the same elements will be omitted. FIG. 10 shows a structure in which a circuit element CLa is further illustrated in the display area DA of FIG. 3. The plan view of FIG. 10 may correspond to the cross-sectional view of FIG. 6.

Referring to FIGS. 6 and 10, the circuit element CLa may be disposed to overlap the third light emitting area PXA-B and the second sub-light emitting area PXA-R2 in a plan view. The circuit element layer DP-CLb may include the insulating layer 40 (refer to FIG. 8) including the first portion P1b with the relatively lower height and the second portion P2b with the relatively higher height. The portion of the insulating layer 40, which is disposed above the circuit element CLa, may be defined as the second portion P2b, and the portion of the insulating layer 40, which is disposed above the area where the circuit element CLa is not disposed, may be defined as the first portion P1b. The second portion P2b may have the height higher than that of the first portion P1b due to the thickness of the circuit element CLa.

The invention should not be construed as being limited to the embodiments set forth herein. Rather, these embodiments are provided so that this invention will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display panel (DP) comprising:
a circuit element layer (DP-CL) including a lower surface (B_CL) and an upper surface (U_CL) facing the lower surface (B_CL), wherein the circuit element layer (DP-CL) comprises a circuit element (CL) and an insulating layer (40);
a display element layer (DP-OLED) on the circuit element layer (DP-CL), wherein the display element layer (DP-OLED) comprises a first light emitting element (ED-R) which emits a first color light, a second light emitting element (ED-G) which emits a second color light different from the first color light, and a third light emitting element (ED-B) which emits a third color light different from the first and second color lights; and
an encapsulation layer (FE) on the display element layer (DP-OLED),
wherein the first light emitting element (ED-R) comprises a first sub-light emitting element (ED-R1) and a second sub-light emitting element (ED-R2), and
a first length (L 1) from the lower surface (B_CL) of the circuit element layer (DP-CL) to the upper surface (U_CL) of the circuit element layer (DP-CL) on which an anode (AE-R1) of the first sub-light emitting element (ED-R1) is disposed is different from a second length (L2) from the lower surface (B_CL) of the circuit element layer (DP-CL) to the upper surface (U_CL) of the circuit element layer (DP-CL) on which an anode (AE-R2) of the second sub-light emitting element (ED-R2) is disposed.

2. The display panel (DP) of claim 1, wherein
the insulating layer (40) of the circuit element layer (DP-CL) has a step, and
the insulating layer (40) comprises a first portion (P1) with a relatively lower height of its upper surface (U_CL) and/or a relatively smaller thickness and a second portion (P2) with a relatively higher height of its upper surface (U_CL) and/or a relatively larger thickness.

3. A display panel (DP) comprising:
a circuit element layer (DP-CL) including a lower surface (B_CL) and an upper surface (U_CL) facing the lower surface (B_CL), wherein the circuit element layer (DP-CL) comprises a circuit element (CL) and an insulating layer (40);
a display element layer (DP-OLED) on the circuit element layer (DP-CL), wherein the display element layer (DP-OLED) comprises a first light emitting element (ED-R) which emits a first color light, a second light emitting element (ED-G) which emits a second color light different from the first color light, and a third light emitting element (ED-B) which emits a third color light different from the first and second color lights; and
an encapsulation layer (FE) on the display element layer (DP-OLED),
wherein the first light emitting element (ED-R) comprises a first sub-light emitting element (ED-R1) and a second sub-light emitting element (ED-R2), and
the insulating layer (40) comprises a first portion (P1) with a relatively lower height of its upper surface (U_CL) and a second portion (P2) with a relatively higher height of its upper surface (U_CL).

4. The display panel (DP) of claim 3, wherein a first length (L1) from the lower surface (B_CL) of the circuit element layer (DP-CL) to the upper surface (U_CL) of the circuit element layer (DP-CL) on which an anode (AE-R1) of the first sub-light emitting element (ED-R1) is disposed is smaller than a second length (L2) from the lower surface (B_CL) of the circuit element layer (DP-CL) to the upper surface (U_CL) of the circuit element layer (DP-CL) on which an anode (AE-R2) of the second sub-light emitting element (ED-R2) is disposed.

5. The display panel (DP) of at least one of claims 2 to 4, wherein
the first portion (P1) overlaps the first sub-light emitting element (ED-R1), and
the second portion (P2) overlaps the second sub-light emitting element (ED-R2).

6. The display panel (DP) of at least one of claims 2 to 5, wherein the circuit element (CL) of the circuit element layer (DP-CL) overlaps the second portion (P2).

7. The display panel (DP) of claim 1 or 2 or of at least one of claims 4 to 6, wherein a third length (L3) from the lower surface (B_CL) of the circuit element layer (DP-CL) to the upper surface (U_CL) of the circuit element layer (DP-CL) on which an anode (AE-G) of the second light emitting element (ED-G) is disposed and a fourth length (L4) from the lower surface (B_CL) of the circuit element layer (DP-CL) to the upper surface (U_CL) of the circuit element layer (DP-CL) on which an anode (AE-B) of the third light emitting element (ED-B) is disposed are substantially the same as the second length (L2).

8. The display panel (DP) of claim 1 or 2 or of at least one of claims 4 to 6, wherein a third length (L3a) from the lower surface (B_CL) of the circuit element layer (DP-CLa) to the upper surface (U_CL) of the circuit element layer (DP-CLa) on which an anode (AE-G) of the second light emitting element (ED-Ga) is disposed and a fourth length (L4a) from the lower surface (B_CL) of the circuit element layer (DP-CLa) to the upper surface (U_CL) of the circuit element layer (DP-CLa) on which an anode (AE-B) of the third light emitting element (ED-Ba) is disposed are substantially the same as the first length (L1).

9. The display panel (DP) of claim 1 or 2 or of at least one of claims 4 to 6, wherein
a third length (L3b) from the lower surface (B_CL) of the circuit element layer (DP-CLb) to the upper surface (U_CL) of the circuit element layer (DP-CLb) on which an anode (AE-G) of the second light emitting element (ED-Gb) is disposed is substantially the same as the first length (L1), and
a fourth length (L4b) from the lower surface (B_CL) of the circuit element layer (DP-CLb) to the upper surface (U_CL) of the circuit element layer (DP-CLb) on which an anode (AE-B) of the third light emitting element (ED-Bb) is disposed is substantially the same as the second length (L2).

10. The display panel (DP) of claim 1 or 2 or of at least one of claims 4 to 9, wherein the first length (L1) is smaller than the second length (L2).

11. The display panel (DP) of at least one of claims 1 to 10, further comprising:
a coupling member (CM) which couples the display element layer (DP-OLED) to the encapsulation layer (FE).

12. The display panel (DP) of at least one of claims 1 to 11, wherein the encapsulation layer (FE) is a glass substrate.

13. An electronic device (ED) comprising:
a display panel (DP) according to at least one of claims 1 to 12 which displays an image;
a window (WP) on the display panel (DP); and
a housing (HAU) disposed under the display panel (DP) and coupled to the window (WP).

14. A method of manufacturing a display panel (DP), the method comprising:
forming a circuit element (CL) on a base layer (BL);
forming an insulating layer (40) to cover the circuit element (CL);
forming a first light emitting element (ED-R) which emits a first color light on the insulating layer (40);
forming a second light emitting element (ED-G) which emits a second color light different from the first color light on the insulating layer (40);
forming a third light emitting element (ED-B) which emits a third color light different from the first and second color lights on the insulating layer (40); and
forming an encapsulation layer (FE) on the first, second, and third light emitting elements (ED-R, ED-G, ED-B),
wherein the forming the first light emitting element (ED-R) on the insulating layer (40) comprises:
forming a first sub-light emitting element (ED-R1); and
forming a second sub-light emitting element (ED-R2),
wherein a first length (L1) from a lower surface (B_CL) of the circuit element (CL) to an upper surface (U_CL) of the circuit element (CL) on which an anode (AE-R1) of the first sub-light emitting element (ED-R1) is disposed is smaller than a second length (L2) from the lower surface (B_CL) of the circuit element (CL) to the upper surface (U_CL) of the circuit element (CL) on which an anode (AE-R2) of the second sub-light emitting element (ED-R2) is disposed.

15. The method of claim 14, wherein the forming the insulating layer (40) to cover the circuit element (CL) comprises forming the insulating layer (40) comprising a first portion (P1) with a relatively lower height of its upper surface (U_CL) and a second portion (P2) with a relatively higher height of its upper surface (U_CL), wherein the first portion (P1) overlaps the first sub-light emitting element (ED-R1), and the second portion (P2) overlaps the second sub-light emitting element (ED-R2).

16. The method of claim 14 or 15, wherein the forming the insulating layer (40) to cover the circuit element (CL) comprises:
forming a preliminary insulating layer covering the circuit element (CL);
placing a mask (MK) comprising a transmission portion (TTA) through which a light is transmitted, a non-transmission portion (NTA) by which the light is blocked, and a semi-transmission portion (HTA) having a light transmittance lower than the transmission portion (TTA) on the preliminary insulating layer; and
radiating the light onto the preliminary insulating layer through the mask (MK) to form the insulating layer (40) comprising a first portion (P1) with a relatively lower height of its upper surface (U_CL) and a second portion (P2) with a relatively higher height of its upper surface (U_CL), wherein the first portion (P1) is formed by the semi-transmission portion (HTA), and the second portion (P2) is formed by the non-transmission portion (NTA).

17. The method of claim 14, 15 or 16, wherein the forming the insulating layer (40) to cover the circuit element (CL) comprises forming the insulating layer (40) comprising a first portion (P1) with a relatively lower height of its upper surface (U_CL) and a second portion (P2) with a relatively higher height of its upper surface (U_CL), wherein the second portion (P2) overlaps the circuit element (CL).
